# EUROPÄISCHE PATENTSCHRIFT

(11) **EP 3 625 805 B1**
(45) Veröffentlichungstag und Bekanntmachung des Hinweises auf die Patenterteilung: **23.06.2021**
(21) Anmeldenummer: 18729578.7
(22) Anmeldetag: 15.05.2018
(51) Int. Cl.: H01C 1/022, H01C 1/14, H01C 1/08, H01C 1/012, H01C 1/084, H01C 1/144, H01C 7/00, H05K 1/02, H01C 3/12, H05K 3/12, H05K 1/16

(54) **LEISTUNGSWIDERSTAND**
POWER RESISTOR
RÉSISTANCE DE PUISSANCE

(30) Priorität: 16.05.2017 EP 17171425
(43) Veröffentlichungstag der Anmeldung: 25.03.2020
(73) Patentinhaber: EBG Elektronische Bauelemente GmbH, 4663 Laakirchen (AT)
(72) Erfinder: FUCHS, Alexander, 8345 Straden (AT); RATZI, Raimund Leopold, 4600 Wels (AT)
(74) Vertreter: Jell, Friedrich
(86) Internationale Anmeldenummer: PCT/EP2018/062631
(87) Internationale Veröffentlichungsnummer: WO 2018/210889

(56) Entgegenhaltungen:
- EP-A2- 0 454 904
- EP-A2- 1 006 766
- DE-A1- 19 910 500
- DE-A1-102010 008 074
- JP-A- H0 883 701

## Beschreibung

### Technisches Gebiet

Die Erfindung betrifft einen Leistungswiderstand mit elektrischen Anschlüssen, mit mindestens einem mit Vergussmasse vergossenem Widerstandsgehäuse, das mindestens ein Widerstandselement, insbesondere aus einem Dickschichtmaterial, und das an einer ersten Außenseite eine erste Anlagefläche für einen Kühlkörper ausbildet, und mit einer elektronischen Schaltung zur Diagnose und/oder Überwachung des Leistungswiderstands.

### Stand der Technik

Bei leistungselektronischen Bauelementen bzw. Leistungsbauteilen ist es bekannt, Schaltungen mit einer Schutz- und Überwachungsfunktion vorzusehen. In diesem Zusammenhang ist zudem bekannt (DE4036426A1), diese elektronische Schaltung im Gehäuse des Leistungsbauteils anzuordnen. Solch eine Anordnung kann zwar die Genauigkeit der Schaltung in deren Schutz- und Überwachungsfunktion erhöhen, unterwirft diese Schaltung jedoch der Temperatur des leistungselektronischen Teils des Leistungsbauteils, was die Lebensdauer der Schaltung zur Überwachung des Leistungswiderstands beeinträchtigen kann. Dies trifft insbesondere für Leistungswiderstände zu, die aufgrund ihrer Verlustleistungen eine hohe Wärmeentwicklung aufweisen.

Die elektronische Schaltung außen am Gehäuse des Leistungsbauteils vorzusehen, um damit die thermische Belastung der Schaltung durch die Verlustleistung zu reduzieren, erhöht jedoch das Beschädigungsrisiko - beispielsweise durch mechanisehe, chemische etc. Kräfte, wodurch nachteilige Auswirkungen auf die Standfestigkeit des Leistungsbauteils nicht ausgeschlossen sind.

### Darstellung der Erfindung

Die Erfindung hat sich daher die Aufgabe gestellt, einen Leistungswiderstand mit zur Diagnose und/oder Überwachung des Leistungswiderstands der eingangs geschilderten Art derart konstruktiv zu verändern, dass selbst bei hohen Verlustleistungen eine erhöhte Standfestigkeit erreicht werden kann.

Die Erfindung löst die gestellte Aufgabe dadurch, dass der Leistungswiderstand ein Aufsteckgehäuse aufweist, das unter Freihaltung der ersten Anlagefläche zum, insbesondere lösbaren, mechanischen Verbinden mit dem Widerstandsgehäuse ausgebildet ist und die Schaltung verkapselt aufnimmt.

Weist der Leistungswiderstand ein Aufsteckgehäuse auf, das unter Freihaltung der ersten Anlagefläche zum mechanischen Verbinden mit dem Widerstandsgehäuse ausgebildet ist, kann zunächst die Gefahr einer Beeinträchtigung der Wärmeableitung des Leistungswiderstands durch das Aufsteckgehäuse geringgehalten werden. Am Widerstandselement des Leistungswiderstands ist sohin eine hohe Standfestigkeit sicherstellbar. Nimmt zudem das Aufsteckgehäuse die Schaltung verkapselt auf, kann die elektronische Schaltung - trotz des Vorsehens außen am Widerstandsgehäuse - von Beschädigungen ausreichend geschützt bleiben. Es ist daher vermeidbar, die elektronische Schaltung in der Nähe des Widerstandselements vorsehen zu müssen, wodurch diese Schaltung auch an einer eher temperaturneutralen Position am Leistungswiderstand positioniert werden kann. Die Schaltung kann daher gegenüber vergleichsweise hohen Temperaturen, verursacht durch Verlustleistung am Widerstandselement, geschützt werden - was eine Beeinträchtigung der Lebensdauer der Schaltung geringhält und damit insgesamt die Standfestigkeit des Leistungswiderstands weiter verbessert.

Die Verkapselung der Schaltung kann beispielsweise durch eine Vergussmasse erfolgen, beispielsweise beim Formen des Aufsteckgehäuses, beispielsweise mit einem Spritzgussverfahren, entstehen, beispielsweise durch ein geschlossenes Aufsteckgehäuse etc. gebildet werden.
Außerdem kann durch ein vorzugsweise lösbares mechanisches Verbinden des Aufsteckgehäuses mit dem Widerstandsgehäuse eine gegebenenfalls erforderliche Wartung der Schaltung vergleichsweise einfach vorgenommen werden, was die Lebensdauer des erfindungsgemäßen Leistungswiderstands hochhält und auch dessen Handhabungsfreundlichkeit verbessert.

Die Temperaturbelastung der Schaltung aufgrund der Verlustleistung am Widerstandselement kann weiter verringert werden, wenn das Aufsteckgehäuse an einer der ersten Außenseite gegenüberliegenden Außenseite des Widerstandsgehäuses vorgesehen ist. Zudem kann dies auch die Wartung des Leistungswiderstands erleichtern, indem die elektronische Schaltung im Wesentlichen unbeeinträchtigt durch bauliche Maßnahmen auf der Kühlkörperseite des Leistungswiderstands zugänglich ist.

Weist das Aufsteckgehäuse mindestens eine Aussparung zur Durchführung der elektrischen Anschlüsse des Leistungswiderstands auf, kann ein an der Anschlussseite des Widerstandsgehäuses vorsehbares und damit handhabungsfreundliches Aufsteckgehäuse geschaffen werden, das -auch nachträglich- mit dem Widerstandsgehäuse verbunden werden kann. Außerdem kann das Aufsteckgehäuse damit die Anschlüsse des Leistungswiderstands schützen und so die Standfestigkeit des Leistungswiderstands weiter erhöhen.

Eine sichere und einfach handzuhabende elektrische Verbindung zwischen dem Widerstandsgehäuse und der elektronischen Schaltung im Aufsteckgehäuse kann ermöglicht werden, wenn zwischen Widerstandsgehäuse und Aufsteckgehäuse wenigstens eine elektrische Steckverbindung vorgesehen ist. Diese elektrische Steckverbindung kann zur Übertragung von Sensordaten und/oder zur Leistungsversorgung der Schaltung zur Diagnose und/oder Überwachung des Leistungswiderstands genützt werden.

Vorzugsweise ist diese elektrische Steckverbindung gegenüber Verschmutzung und/oder Feuchtigkeit resistent ausgebildet, um eine gegenüber Umweltbelastungen standfeste Kontaktverbindung sicherstellen zu können.

Weist die die Schaltung eine Leiterplatte auf, die mindestens einen Steckverbinder der Steckverbindung trägt, können die Kompaktheit und Robustheit des Aufsteckgehäuses verbessert werden.

Letztgenannte Vorteile sind besonders ausgeprägt, wenn das Aufsteckgehäuse die Schaltung verkapselt aufnimmt. Hierzu kann beispielsweise das Aufsteckgehäuse Vergussmasse aufweisen, die die Schaltung verkapselt. Zudem kann die Vergussmasse der thermischen Leitfähigkeit der Schaltung dienlich sein und die Wärmebelastung durch die Abwärme des Widerstandselements weiter reduzieren. Alternativ ist vorstellbar, dass beim Ummanteln der Schaltung das Aufsteckgehäuse ausgebildet wird, beispielsweise mit einem Spritzgussverfahren, vorzugsweise einem Niederdruck-Spritzgussverfahren (Low-Pressure-Moulding Verfahren).

Eine sichere und standfeste Befestigung des Aufsteckgehäuses am Widerstandsgehäuse ist erreichbar, wenn das Widerstandsgehäuse mindestens eine Montageöffnung und das Aufsteckgehäuse mindestens eine Befestigungsöffnung aufweisen, welche beiden Öffnungen zueinander fluchtend angeordnet sind. Befestigungsmittel können derart beide Gehäuse durchgreifen und diese gemeinsam verankern.

Genaue Messdaten zur Diagnose bzw. Überwachung des Leistungswiderstands können vom Widerstandselement aufgenommen werden, wenn der Leistungswiderstand einen Sensor-Bauelement mit mindestens einem Sensor und mit wenigstens einer mit dem Sensor signalverbundenen Messeinrichtung aufweist, wobei der Sensor im Widerstandsgehäuse vorgesehen ist und die elektronischen Schaltung die Messeinrichtung aufweist. Sensor und Widerstandselement können sohin nahe zueinander positioniert vorgesehen werden, wodurch beispielsweise genaue Sensordaten zur aktuellen Temperatur des Widerstandselements erfassbar sind.

Eine bekannte konstruktive Ausführung des Leistungswiderstands im Bereich des Leistungsgehäuses kann im Wesentlichen beibehalten werden, wenn das Widerstandsgehäuse ein erstes, insbesondere elektrisch isolierendes, Substrat, auf dem das Widerstandselement aufgebracht ist, und ein zweites, insbesondere elektrisch isolierendes, Substrat mit dem Sensor aufweist, wobei die beiden Substrate voneinander beabstandet im Widerstandsgehäuse positioniert sind. Zudem kann durch diese Trennung der beiden Substrate eine mechanische und elektrische Isolation zwischen den Funktionselementen des Leistungswiderstands erhöhen - und damit dessen Sicherheit weiter verbessern.

Vorzugsweise kann das zweite elektrische Substrat direkt auf dem Widerstandselement angebracht sein, um beispielsweise die Temperaturmessung zu verbessern. Alternativ kann dazu kann das Sensor auf dem Widerstandselement oder auf dessen Substrat angebracht sein, um den Konstruktionsaufwand am Leistungswiderstands zu vermindern.

Wird die elektrische Schaltung im Aufsteckgehäuse von einer Netzschaltung im Widerstandsgehäuse elektrisch versorgt, kann dies den konstruktiven Aufwand am Aufsteckgehäuse weiter reduzieren bzw. den Leistungswiderstand vereinfachen.

Die elektrische Sicherheit des Widerstandselements kann erhöht werden, wenn die die Schaltung im Aufsteckgehäuse drahtlos Versorgungsenergie empfängt und/oder eine drahtlose Datenübertragung aufweist.

Vorzugsweise weist die Schaltung im Aufsteckgehäuse eine autarke Energieversorgung auf, um elektrisch unabhängig vom Hauptanschluss des Leistungswiderstands Diagnose und/oder Überwachungsaufgaben erfüllen zu können.

Im Allgemeinen wird erwähnt, dass das Widerstandselement ein Dickfilmwiderstand sein kann. Solch ein Widerstandselement kann beispielsweise durch Aufbringen von Ruthenium-basierten Widerstandspasten, Cermet, etc. auf das Substrat ausgebildet werden.

Im Allgemeinen wird weiter erwähnt, dass eine Kontaktelektrode zum elektrischen Anschluss eines Widerstandselements eine AgPd oder AgPt-Dickfilmpaste etc. aufweisen kann.

Zudem wird im Allgemeinen erwähnt, dass das elektrisch isolierende Substrat vorzugsweise plattenförmig ist. Dieses Substrat kann Keramik und/oder ein keramikartiges Material, vorzugsweise Aluminiumoxidkeramik, etc. aufweist. Auch kann das Substrat ein Verbundwerkstoff mit Keramik und/oder einem keramikartigen Material sein, beispielsweise mit zwei äußeren Keramikplatten mit einer dazu mittigen Metallplatte.

### Kurze Beschreibung der Zeichnungen

In den Figuren ist beispielsweise der Erfindungsgegenstand anhand einer Ausführungsvariante näher dargestellt. Es zeigen
- Fig. 1: eine teilweise aufgerissene Schnittansicht durch einen Leistungswiderstand mit aufgesetztem Aufsteckgehäuse und
- Fig. 2: eine aufgerissene Schnittansicht nach II-II der Fig. 1 mit getrennt dargestelltem Widerstand- und Aufsteckgehäuse.

### Weg zur Ausführung der Erfindung

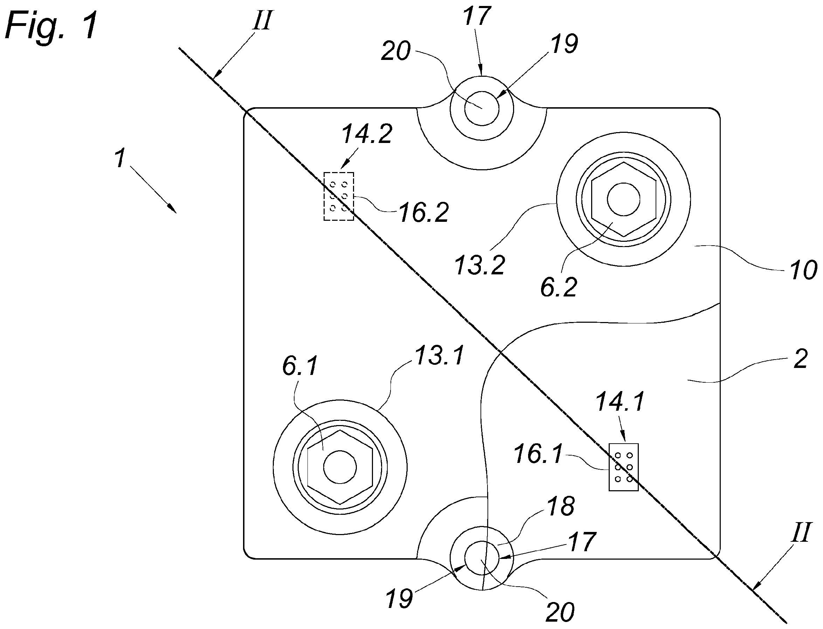

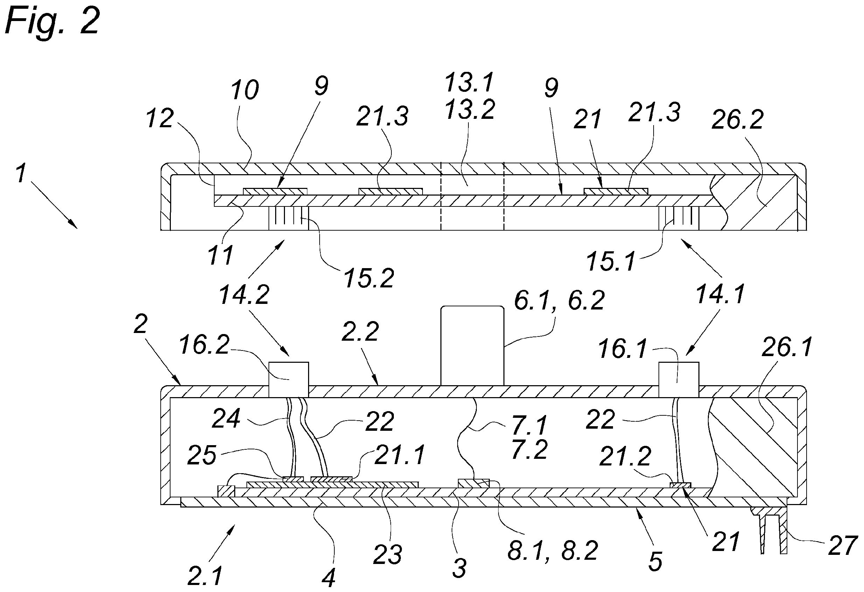

Gemäß Fig. 1 wird beispielsweise ein Leistungswiderstand 1 mit einem Widerstandsgehäuse 2 dargestellt. Das Widerstandsgehäuse 2 ist mit einer Vergussmasse 26.1 vergossenen und verkapselt ein Widerstandselement 3 - wie in Fig. 2 zu erkennen. Dieses Widerstandselement 3 -beispielsweise aus einem Dickschichtmaterial- ist auf einem plattenförmigen, elektrisch isolierenden Substrat 4, beispielsweise Aluminiumoxidkeramik, aufgebracht - wodurch sich eine Schichtschaltung 30 ausbildet. Das Substrat 4 dient als Träger und außerdem zur Wärmeleitung. Hierfür bildet das Substrat 4 eine plane Anlagefläche 5 an einer ersten Außenseite 2.1 des Widerstandsgehäuses 2 aus, welche Anlagefläche 5 mit dem Widerstandselements 3 thermisch verbunden ist, die Verlustwärme des Widerstandselements 3 abzuführen. Zudem ist die Anlagefläche 5 zum thermischen Koppeln mit einem Kühlkörper 27 geeignet. Der Kühlköper kann passiv kühlen, beispielsweise hierfür Kühlrippen aufweisen, oder auch aktiv kühlen, beispielsweise mit einer wassergekühlten Platte.

Zudem sind am Leistungswiderstand 1 zwei elektrische Anschlüsse 6.1, 6.2 vorgesehen, die am Leistungswiderstand 1 die Leistungsanschlüsse ausbilden. Die elektrischen Anschlüsse 6.1, 6.2 sind über elektrische Leiter 7.1, 7.2, beispielsweise Drähte, mit den elektrischen Kontaktelektrode 8.1, 8.2 verbunden, zwischen denen das Widerstandselement 3 vorgesehen ist.
Des Weiteren ist der Leistungswiderstand 1 mit einer elektronischen Schaltung 9 zu seiner Diagnose und/oder Überwachung versehen, beispielsweise kann damit das Widerstandselement 3 überwacht bzw. dessen Temperatur erfasst werden.

Diese erfassten Daten können drahtlos oder drahtgebunden weiterübertragen oder von der Schaltung verarbeitet und dann drahtlos oder drahtgebunden weiterübertragen werden, was nicht weiter dargestellt worden ist. Zudem ist auch denkbar, dass die Schaltung mit einer optische Anzeigt etc. am Aufsteckgehäuse verbunden ist, Zustandsdaten zum Leistungswiderstand auszugeben, was ebenso nicht näher dargestellt worden ist.

Für diese elektronische Schaltung 9 weist erfindungsgemäß der Leistungswiderstand 1 nun ein Aufsteckgehäuse 10 auf. Dieses Aufsteckgehäuse 10 ist unter Freihaltung der Anlagefläche 5 an der ersten Außenseite 2.1 zum lösbaren mechanischen Verbinden mit dem Widerstandsgehäuse 2 ausgebildet. Dies ist in Fig. 2 daran erkennbar, dass das Aufsteckgehäuse 10 an einer der ersten Außenseite 2.1 gegenüberliegenden Außenseite 2.2 des Widerstandsgehäuses 2 vorgesehen ist.

Das Aufsteckgehäuse 10 nimmt zudem die Schaltung 9 zur Überwachung des Widerstandselements 3 auf - und zwar verkapselt, wie dies in Fig. 2 anhand der teilweise dargestellten Vergussmasse 26.2 erkannt werden kann, die das Aufsteckgehäuse 10 vollständig ausfüllt. Die elektronischen Schaltung 9 kann sohin gegenüber mechanischen Belastungen besonders gut geschützt werden. Zudem erhöht dies die Stabilität des Aufsteckgehäuses 10. Ein standfester Leistungswiderstand 1 ist damit geschaffen. Alternativ kann das Aufsteckgehäuse 10 auch durch ein Ummantelungsverfahren, z.B. Spritzgussverfahren, vorzugsweise einem Low-Pressure-Moulding Verfahren, der elektronischen Schaltung 9 hergestellt werden, was nicht näher dargestellt worden ist.

Im Allgemeinen wird erwähnt, dass das Aufsteckgehäuse 10 mit dem Widerstandsgehäuse 2 kraftschlüssig, formschlüssig oder auch stoffschlüssig mechanisch verbunden werden kann - beispielsweise über Schnappverbindungen, Klettverschlüsse oder auch mit Klebstoffen. Bevorzugt erfolgt dies jedoch mit lösbaren mechanischen Verbindungen.

Die verkapselte Schaltung 9 ist am Aufsteckgehäuse 10 zudem befestigt, wofür zwischen der Leiterplatte 11 der elektronischen Schaltung 9 und dem Aufsteckgehäuse 10 Halteelemente 12 vorgesehen sind, wie dies in Fig. 2 erkannt werden kann.

Das Aufsteckgehäuse 10 umfasst zudem zwei Aussparung 13.1, 13.2, welche der Durchführung der elektrischen Anschlüsse 6.1, 6.2 dienen. Damit kann das Aufsteckgehäuse 10 selbst auf der Gehäuseseite 2.1 des Widerstandsgehäuses 2 vorgesehen werden, das die elektrischen Anschlüsse 6.1, 6.2 trägt. Die kompakte Bauform des Leistungswiderstands 1 bleibt derart trotz eines zusätzlichen Gehäuses, nämlich des Aufsteckgehäuses 10, erhalten.

Zur Übermittlung von Daten und zur elektrischen Leistungsversorgung der Schaltung 9 sind zwischen dem Widerstandsgehäuse 2 und dem Aufsteckgehäuse 10 zwei elektrische Steckverbindungen 14.1, 14.2 vorgesehen. In diesem Zusammenhang wird im Allgemeinen erwähnt, dass diese Funktionen, nämlich Übermittlung von Daten und/oder elektrische Leistungsversorgung, alternativ auch mit Hilfe einer drahtlosen Verbindung ermöglicht werden kann, was in den Figuren nicht dargestellt ist.

Die beiden elektrischen Steckverbindungen 14.1, 14.2 sind gegenüber Verschmutzung und/oder Feuchtigkeit resistent ausgebildet, beispielsweise über Dichtlippen wasserdicht zur Kontaktstelle hin ausgeführt.

Die Steckverbinder 15.1, 15.2 der elektrischen Steckverbindungen 14.1, 14.2 sind an der Leiterplatte 11 befestigt, insbesondere dort aufgelötet, wodurch die Leiterplatte 11 diese Steckverbinder 15.1, 15.2 trägt. Die dazu passenden Gegensteckverbinder 16.1, 16.2 sind am Widerstandsgehäuse 2 befestigt.

Das Aufsteckgehäuse 10 wird mechanisch am Widerstandsgehäuse 2 über die elektrischen Steckverbindungen 14.1, 14.2 gehalten, welche beispielsweise hierfür nicht näher dargestellte Schnappverbindungen aufweisen. Zudem oder alternativ wird diese Befestigung durch eine Schraubverbindung 17 verstärkt. Hierzu weisen das Widerstandsgehäuse 2 zwei Montageöffnungen 18 und das Aufsteckgehäuse 10 mindestens zwei Befestigungsöffnungen 19 auf, welche beiden Öffnungen 18, 19 zueinander fluchtend angeordnet sind und jeweils von Befestigungsmitteln 20, beispielsweise Schrauben, durchgriffen werden.

Wie in Fig. 2 zu erkennen, ist im Widerstandsgehäuse 2 ein erster Sensor 21.1, zur Messung der Temperatur, vorgesehen, der auf einem zweiten elektrisch isolierenden Substrat 23 vorgesehen ist. Der Sensor 21.1 ist mit der elektronischen Schaltung 9 des Aufsteckgehäuses 10 über Signalleitungen 22 analog signalverbunden. Hiezu weist die elektronischen Schaltung 9 eine Messeinrichtung 21.3 auf, die die Sensordaten des Sensors 21.1 verarbeitet. Messeinrichtung 21.3 und Sensor 21.1 bilden sohin am Leistungswiderstand 1 einen Sensor-Bauelement 21 aus. Dieses Sensorbauelement weist zudem im Widerstandsgehäuse 2 einen zweiten Sensor 21.2 auf, der als Shunt Widerstand zur Messung elektrischer Größen ausgebildet ist. Auch dieser Sensor 21.2 ist über Signalleitungen 22 mit der Messeinrichtung 21.3 der elektronischen Schaltung 9 im Aufsteckgehäuse 10 analog signalverbunden.

Des Weiteren ist auf dem zweiten elektrisch isolierenden Substrat 23 eine Netzschaltung 25, beispielsweise ein Spannungsteiler, vorgesehen, welche über Versorgungsleitungen 24 mit der Schaltung 9 im Aufsteckgehäuse 10 elektrisch verbunden ist - und diese Schaltung 9 mit elektrischer Energie versorgt. Eingangsseitig hängt diese Netzschaltung 25 am Anschlusspotential des Leistungswiderstands 1. Alternativ ist aber auch eine autarke elektrische Leistungsversorgung im Aufsteckgehäuse 10 denkbar, was in den Figuren nicht dargestellt ist.

Das ersten elektrisch isolierende Substrat 4 ist vom zweiten elektrisch isolierenden Substrat 23 beabstandet im Widerstandsgehäuse 2 positioniert angeordnet. Vorzugsweise ist das zweite elektrisch isolierende Substrat 23 auf dem Widerstandselement 3 direkt angebracht. Alternativ ist auch vorstellbar, was nicht dargestellt worden ist, den Sensor 21.1 auf dem Widerstandselement 3 direkt anzubringen, was nicht näher dargestellt worden ist.

Im Allgemeinen wird festgehalten, dass der Leistungswiderstand eine Vielzahl an unterschiedlichen elektrischen, physikalischen etc. Sensoren aufweisen kann, beispielsweise auch Magnetfeldsensoren, die auch im Aufsteckgehäuse 10 vorgesehen sein können, was nicht näher dargestellt worden ist.

## Patentansprüche

1. Leistungswiderstand mit elektrischen Anschlüssen (6.1, 6.2), mit mindestens einem mit Vergussmasse (26.1) vergossenem Widerstandsgehäuse (2), das mindestens ein Widerstandselement (3), insbesondere aus einem Dickschichtmaterial, aufweist und das an einer ersten Außenseite (2.1) eine erste Anlagefläche (5) für einen Kühlkörper (27) ausbildet, und mit einer elektronischen Schaltung (9) zur Diagnose und/oder Überwachung des Leistungswiderstands (1), **dadurch gekennzeichnet, dass** der Leistungswiderstand (1) ein Aufsteckgehäuse (10) aufweist, das unter Freihaltung der ersten Anlagefläche (5) zum, insbesondere lösbaren, mechanischen Verbinden mit dem Widerstandsgehäuse (2) ausgebildet ist und die Schaltung (9) verkapselt aufnimmt.

2. Leistungswiderstand nach Anspruch 1, **dadurch gekennzeichnet, dass** das Aufsteckgehäuse (10) an einer der ersten Außenseite (2.1) gegenüberliegenden Außenseite (2.2) des Widerstandsgehäuses (2) vorgesehen ist.

3. Leistungswiderstand nach Anspruch 1 oder 2, **dadurch gekennzeichnet, dass** das Aufsteckgehäuse (10) mindestens eine Aussparung (13.1, 13.2) zur Durchführung der elektrischen Anschlüsse (6.1, 6.2) des Leistungswiderstands (1) aufweist.

4. Leistungswiderstand nach Anspruch 1, 2 oder 3, **dadurch gekennzeichnet, dass** zwischen Widerstandsgehäuse (2) und Aufsteckgehäuse (10) wenigstens eine elektrische Steckverbindung (14.1, 14.2) vorgesehen ist.

5. Leistungswiderstand nach Anspruch 4, **dadurch gekennzeichnet, dass** die elektrische Steckverbindung (14.1, 14.2) gegenüber Verschmutzung und/oder Feuchtigkeit resistent ausgebildet ist.

6. Leistungswiderstand nach Anspruch 4 oder 5, **dadurch gekennzeichnet, dass** die elektrische Schaltung (9) eine Leiterplatte (11) aufweist, die mindestens einen Steckverbinder (15.1, 15.2) der Steckverbindung (14.1, 14.2) trägt.

7. Leistungswiderstand nach einem der Ansprüche 1 bis 6, **dadurch gekennzeichnet, dass** das Aufsteckgehäuse (10) die Schaltung (9) verkapselt aufnimmt, insbesondere hierfür Vergussmasse (26.2) aufweist, die die Schaltung (9) verkapselt.

8. Leistungswiderstand nach einem der Ansprüche 1 bis 7, **dadurch gekennzeichnet, dass** das Widerstandsgehäuse (2) mindestens eine Montageöffnung (18) und das Aufsteckgehäuse (10) mindestens eine Befestigungsöffnung (19) aufweisen, welche beiden Öffnungen (18, 19) zueinander fluchtend angeordnet sind.

9. Leistungswiderstand nach einem der Ansprüche 1 bis 8, **dadurch gekennzeichnet, dass** der Leistungswiderstand (1) einen Sensor-Bauelement (21) mit mindestens einem Sensor (21.1, 21.2) und mit wenigstens einer mit dem Sensor (21.1, 21.2) signalverbundenen Messeinrichtung (21.3) aufweist, wobei der Sensor (21.1, 21.2) im Widerstandsgehäuse (2) vorgesehen ist und die elektronischen Schaltung (9) die Messeinrichtung (21.3) aufweist.

10. Leistungswiderstand nach Anspruch 9, **dadurch gekennzeichnet, dass** das Widerstandsgehäuse (2) ein erstes Substrat (4), auf dem das Widerstandselement (3) aufgebracht ist, und ein zweites Substrat (23) mit dem Sensor (21.1, 21.2) aufweist, wobei die beiden Substrate (4, 23) voneinander beabstandet im Widerstandsgehäuse (2) positioniert sind.

11. Leistungswiderstand nach Anspruch 10, **dadurch gekennzeichnet, dass** das zweite elektrische Substrat (23) direkt auf dem Widerstandselement (3) angebracht ist.

12. Leistungswiderstand nach Anspruch 9, **dadurch gekennzeichnet, dass** das Sensor (21.1, 21.2) direkt auf dem Widerstandselement (3) oder auf dessen Substrat (4) angebracht ist.

13. Leistungswiderstand nach einem der Ansprüche 1 bis 12, **dadurch gekennzeichnet, dass** die elektrische Schaltung (9) im Aufsteckgehäuse (10) von einer Netzschaltung (25) im Widerstandsgehäuse (2) elektrisch versorgt wird.

14. Leistungswiderstand nach einem der Ansprüche 1 bis 13, **dadurch gekennzeichnet, dass** die Schaltung (9) im Aufsteckgehäuse (10) drahtlos Versorgungsenergie empfängt und/oder eine drahtlose Datenübertragung aufweist.

15. Leistungswiderstand nach einem der Ansprüche 1 bis 14, **dadurch gekennzeichnet, dass** die Schaltung (9) im Aufsteckgehäuse (10) eine autarke Energieversorgung aufweist.

## Claims

1. Power resistor with electrical connections (6.1, 6.2), with at least one resistor housing (2) encapsulated with grouting compound (26.1), which resistor housing (2) has at least one resistor element (3), more particularly made of a thick-film material, and which, on a first outer side (2.1) has a first contact surface (5) for a heat sink (27), and with an electronic circuit (9) for diagnosis and/or monitoring of the power resistor (1), **characterized in that** the power resistor (1) has a plug-on housing (10) which is formed for, more particularly releasable, mechanical connection to the resistor housing (2) while keeping the first contact surface (5) free and encapsulates the circuit (9).

2. Power resistor according to claim 1, **characterized in that** the plug-on housing (10) is provided on an outer side (2.2) of the resistor housing (2) opposite the first outer side (2.1).

3. Power resistor according to claim 1 or 2, **characterized in that** the plug-on housing (10) has at least one recess (13.1, 13.2) for the passage of the electrical connections (6.1, 6.2) of the power resistor (1).

4. Power resistor according to claim 1, 2 or 3, **characterized in that** at least one electrical plug connection (14.1, 14.2) is provided between resistor housing (2) and clip-on housing (10).

5. Power resistor according to claim 4, **characterized in that** the electrical plug connection (14.1, 14.2) is designed to be resistant to dirt and/or moisture.

6. Power resistor according to claim 4 or 5, **characterized in that** the electrical circuit (9) has a printed circuit board (11), which bears at least one plug connector (15.1, 15.2) of the plug connection (14.1, 14.2).

7. Power resistor according to one of claims 1 to 6, **characterized in that** the plug-on housing (10) includes the circuit (9) in an encapsulated manner, more particularly for this purpose has potting compound (26.2), which encapsulates the circuit (9).

8. Power resistor according to one of claims 1 to 7, **characterized in that** the resistor housing (2) has at least one assembly opening (18) and the clip-on housing (10) has at least one fastening opening (19), which two openings (18, 19) are aligned with each another.

9. Power resistor according to one of claims 1 to 8, **characterized in that** the power resistor (1) has a sensor component (21) with at least one sensor (21.1, 21.2) and with at least one measuring device (21.3) that is signal-connected to the sensor (21.1, 21.2), wherein the sensor (21.1, 21.2) is provided in the resistor housing (2) and the electronic circuit (9) has the measuring device (21.3).

10. Power resistor according to claim 9, **characterized in that** the resistor housing (2) has a first substrate (4) on which the resistor element (3) is applied, and a second substrate (23) with the sensor (21.1, 21.2), wherein the the two substrates (4, 23) are positioned at a distance from one each other in the resistor housing (2).

11. Power resistor according to claim 10, **characterized in that** the second electrical substrate (23) is directly attached to the resistance element (3).

12. Power resistor according to claim 9, **characterized in that** the sensor (21.1, 21.2) is directly attached to the resistance element (3) or to its substrate (4).

13. Power resistor according to one of claims 1 to 12, **characterized in that** the electrical circuit (9) in the clip-on housing (10) is electrically supplied by a mains circuit (25) in the resistor housing (2).

14. Power resistor according to one of claims 1 to 13, **characterized in that** the circuit (9) in the clip-on housing (10) receives supply energy in a wireless way and/or has wireless data transmission.

15. Power resistor according to one of claims 1 to 14, **characterized in that** the circuit (9) in the clip-on housing (10) has a self-sufficient energy supply.

## Revendications

1. Résistance de puissance avec connexions électriques (6.1, 6.2), avec au moins un boîtier de résistance (2) encapsulé avec un composé de jointoiement (26.1), lequel boîtier de résistance (2) comporte au moins un élément de résistance (3), en particulier d'un matériau à film épais, et qui forme une première surface de contact (5) pour un dissipateur thermique (27) sur un premier côté extérieur (2.1), et avec un circuit électronique (9) pour le diagnostic et/ou surveiller la résistance de puissance (1), **caractérisé en ce que** la résistance de puissance (1) présente un boîtier enfichable (10) qui est conçu pour être relié mécaniquement, en particulier amovible, au boîtier de résistance (2) tout en laissant libre la première surface de contact (5) et qui reçoit le circuit (9) de manière encapsulée.

2. Résistance de puissance selon la revendication 1, **caractérisée en ce que** le boîtier enfichable (10) est prévu sur un côté extérieur (2.2) du boîtier de résistance (2) opposé au premier côté extérieur (2.1).

3. Résistance de puissance selon la revendication 1 ou 2, **caractérisée en ce que** le boîtier enfichable (10) présente au moins un évidement (13.1, 13.2) pour le passage des connexions électriques (6.1, 6.2) de la résistance de puissance (1).

4. Résistance de puissance selon la revendication 1, 2 ou 3, **caractérisée en ce qu'**au moins un connecteur électrique (14.1, 14.2) est prévu entre le boîtier de résistance (2) et le boîtier clipsable (10).

5. Résistance de puissance selon la revendication 4, **caractérisée en ce que** le connecteur électrique (14.1, 14.2) est conçu pour résister à la saleté et/ou à l'humidité.

6. Résistance de puissance selon la revendication 4 ou 5, **caractérisée en ce que** le circuit électrique (9) présente une carte de circuit imprimé (11), qui porte au moins un connecteur enfichable (15.1, 15.2) du connecteur enfichable (14.1, 14.2).

7. Résistance de puissance selon l'une des revendications 1 à 6, **caractérisée en ce que** le boîtier enfichable (10) comprend le circuit (9) de manière encapsulée, en particulier à cet effet un composé d'enrobage (26.2), qui encapsule le circuit (9).

8. Résistance de puissance selon l'une des revendications 1 à 7, **caractérisée en ce que** le boîtier de résistance (2) présente au moins une ouverture d'assemblage (18) et le boîtier clipsable (10) présente au moins une ouverture de fixation (19), dont deux les ouvertures (18, 19) sont alignées les unes avec les autres.

9. Résistance de puissance selon l'une des revendications 1 à 8, **caractérisée en ce que** la résistance de puissance (1) comporte un composant capteur (21) avec au moins un capteur (21.1, 21.2) et avec au moins un dispositif de mesure (21.3) qui est un signal - connecté au capteur (21.1, 21.2), dans lequel le capteur (21.1, 21.2) est prévu dans le boîtier de résistance (2) et le circuit électronique (9) comporte le dispositif de mesure (21.3).

10. Résistance de puissance selon la revendication 9, **caractérisée en ce que** le boîtier de résistance (2) comporte un premier substrat (4) sur lequel est appliqué l'élément de résistance (3) et un deuxième substrat (23) avec le capteur (21.1, 21.2), dans lequel les deux substrats (4, 23) sont positionnés à distance l'un de l'autre dans le boîtier de résistance (2).

11. Résistance de puissance selon la revendication 10, **caractérisée en ce que** le deuxième substrat électrique (23) est directement fixé à l'élément de résistance (3).

12. Résistance de puissance selon la revendication 9, **caractérisée en ce que** le capteur (21.1, 21.2) est directement fixé à l'élément de résistance (3) ou à son substrat (4).

13. Résistance de puissance selon l'une des revendications 1 à 12, **caractérisée en ce que** le circuit électrique (9) dans le boîtier clipsable (10) est alimenté électriquement par un circuit secteur (25) dans le boîtier de résistance (2).

14. Résistance de puissance selon l'une des revendications 1 à 13, **caractérisée en ce que** le circuit (9) dans le boîtier clipsable (10) reçoit l'énergie d'alimentation d'une manière sans fil et/ou a une transmission de données sans fil.

15. Résistance de puissance selon l'une des revendications 1 à 14, **caractérisée en ce que** le circuit (9) dans le boîtier clipsable (10) a une alimentation en énergie autonome.
